# FASCICULE DE BREVET EUROPEEN

(11) **EP 2 468 931 B1**
(45) Date de publication et mention de la délivrance du brevet: **10.07.2013**
(21) Numéro de dépôt: 11195129.9
(22) Date de dépôt: 22.12.2011
(51) Int. Cl.: C30B 29/06, C30B 33/06, H01L 21/762, H01L 21/18, H01L 21/20

(54) **Procédé de clivage d'un substrat et ensemble comprenant un substrat et une structure permettant ce clivage**
Verfahren zur Aufspaltung eines Substrats und Substrat-Struktur Zusammenbau der diese Aufspaltung ermöglicht
Method for cleaving a substrate and a substrate-structure assembly enabling this cleavage

(30) Priorité: 22.12.2010 FR 1061052
(43) Date de publication de la demande: 27.06.2012
(73) Titulaire: Soitec, 38190 Bernin (FR)
(72) Inventeur: Bruel, Michel, 38113 Veurey-Voroize (FR)
(74) Mandataire: Regimbeau

(56) Documents cités:
- EP-A1- 0 533 551
- US-A1- 2006 234 486
- US-A1- 2007 249 140
- R. Lakes: "Cellular solid structures with unbounded thermal expansion", JOURNAL OF MATERIALS SCIENCE LETTERS vol. 15, 1 janvier 1996 (1996-01-01), pages 475-477, XP55020834, Extrait de l'Internet: URL:http://www.springerlink.com/content/ku 6q75838g47176l/fulltext.pdf [extrait le 2012-03-02]
- O. SIGMUND ET AL: "Composites with extremal thermal expansion coefficients", APPLIED PHYSICS LETTERS, vol. 69, no. 21, 1 janvier 1996 (1996-01-01), page 3203, XP55020838, ISSN: 0003-6951, DOI: 10.1063/1.117961

## Description

### DOMAINE DE L'INVENTION

La présente invention concerne un procédé de clivage d'un substrat en vue du détachement d'une couche dudit substrat.

### ARRIERE PLAN DE L'INVENTION

Le détachement de couches épaisses d'un substrat se pose particulièrement dans l'industrie des semi-conducteurs.

Différents procédés de détachement sont déjà connus et largement employés.

Certains procédés comprennent la formation, à l'intérieur du substrat, d'une zone de fragilisation délimitant la couche à détacher, puis l'application au substrat ou à la zone de fragilisation, de contraintes visant à provoquer le clivage du substrat suivant la zone de fragilisation. Ces contraintes peuvent être de nature thermique et/ou mécanique, etc.

Ainsi, le procédé Smart Cut ™ comprend la formation, dans un substrat donneur, d'une zone de fragilisation par implantation d'espèces atomiques, délimitant la couche à transférer, suivie du collage du substrat donneur sur un substrat receveur et le clivage du substrat donneur suivant la zone de fragilisation, conduisant au report de la couche sur le substrat receveur.

Cependant, ce procédé est plus approprié au transfert de couches minces, c'est-à-dire d'épaisseur typiquement inférieure au micromètre.

En effet, les implanteurs à vocation industrielle présentent à l'heure actuelle une énergie jusqu'à 200 keV, ce qui permet d'atteindre une profondeur d'implantation pouvant atteindre 2 micromètres environ, selon les matériaux et les espèces ioniques implantées.

Par exemple, une implantation d'ions H+ dans du silicium permet d'atteindre une profondeur de 1,8 micromètres environ, mais la profondeur atteinte sera plus faible dans du GaN qui est plus dense.

Il existe des implanteurs à haute énergie, c'est-à-dire de l'ordre de 1 MeV, qui permettraient d'atteindre une profondeur jusqu'à 20 micromètres, mais le procédé ne serait pas économiquement viable en raison du coût élevé de ces machines.

La demande de brevet US 2007/0249140 décrit un procédé de détachement d'une couche d'un substrat de silicium, dans lequel on dépose une couche métallique, en particulier une pâte à l'argent et/ou à l'aluminium, à la surface du substrat.

L'application d'une contrainte thermique au substrat recouvert de la couche métallique engendre une contrainte de clivage dans le substrat, à une profondeur correspondant à l'épaisseur de la couche que l'on souhaite détacher, conduisant au clivage du substrat et au détachement de la couche désirée.

L'obtention de la contrainte de clivage est liée à la différence de coefficient de dilatation thermique (CTE, acronyme du terme anglo-saxon « Coefficient of Thermal Expansion ») entre le matériau de la couche métallique et le matériau du substrat.

Ainsi, par exemple, le coefficient de dilatation thermique du silicium est de 4,6.10⁻⁶ K⁻¹ tandis que celui de l'argent est de 20.10-⁶ K⁻¹ et celui de l'aluminium de 24.10⁻⁶ K⁻¹.

Cependant, le dépôt de métaux sur le substrat de silicium risque de contaminer la couche semi-conductrice, ce qui est préjudiciable au fonctionnement du dispositif fabriqué à partir de cette couche.

Par ailleurs, le coefficient de dilatation thermique de la couche génératrice de contraintes est dépendant de la nature du matériau employé.

Il en résulte que l'homme du métier est nécessairement limité dans la définition du procédé par les matériaux disponibles sur le marché.

En particulier, il ne peut pas forcément former une couche génératrice de contraintes présentant le coefficient de dilatation thermique souhaité.

Enfin, pour provoquer la dilatation de la couche génératrice de contraintes selon le procédé précité, il est généralement nécessaire de la chauffer à une température élevée, c'est-à-dire typiquement de l'ordre de 800°C.

Cependant, le silicium présente, dans cette gamme de température, un caractère ductile, ce qui est défavorable à l'obtention du clivage du substrat.

L'un des buts de la présente invention est donc de procurer un procédé de détachement d'une couche d'un substrat présentant une épaisseur typiquement comprise entre 1 et 100 micromètres qui évite les inconvénients des méthodes évoquées plus haut.

Plus précisément, l'invention vise à permettre le détachement d'une couche d'un substrat sans risquer de contaminer le matériau du substrat.

L'invention a également pour but de limiter la température nécessaire pour procurer le clivage du substrat.

En outre, l'invention doit également procurer une plus grande liberté de choix dans le coefficient de dilatation thermique de la structure génératrice de contraintes, en vue notamment d'optimiser le clivage du substrat.

### BREVE DESCRIPTION DE L'INVENTION

Conformément à l'invention, il est proposé un procédé de clivage d'un substrat en vue d'en détacher une couche, comprenant les étapes successives suivantes :
(i) la formation d'une structure dite génératrice de contraintes, solidaire localement de la surface du substrat, ladite structure génératrice de contraintes étant une structure cellulaire dont les parois des cellules sont perpendiculaires à la surface du substrat et sont composées d'au moins deux matériaux présentant des coefficients de dilatation thermique différents agencés pour permettre une déformation desdites parois sous l'effet d'un traitement thermique, de sorte que ladite structure est adaptée pour se dilater ou se contracter dans un plan parallèle à la surface du substrat sous l'effet dudit traitement thermique,
(ii) l'application à ladite structure d'un traitement thermique adapté pour provoquer la dilatation ou la contraction de ladite structure de manière à générer dans le substrat une pluralité de contraintes locales dont la combinaison génère une contrainte supérieure à la résistance mécanique du substrat dans un plan de clivage parallèle à la surface du substrat définissant la couche à détacher, ladite contrainte conduisant au clivage du substrat selon ledit plan.

Par « solidaire » on entend dans le présent texte que la force de cohésion entre la structure génératrice de contraintes et la surface du substrat doit être supérieure aux contraintes exercées lors de la dilatation ou la contraction de la structure, pour qu'il n'y ait pas de rupture à l'interface et que les contraintes engendrées par la déformation de la structure soient transmises au substrat pour permettre son clivage.

Par « localement » on entend que la liaison entre la structure génératrice de contraintes et le substrat n'existe que dans des régions déterminées de la surface du substrat, et non en tout point de la surface du substrat.

De manière particulièrement avantageuse, les au moins deux matériaux présentant des coefficients de dilatation thermique différents agencés pour permettre une déformation desdites parois sous l'effet dudit traitement thermique, procurent un effet bilame.

Par « procurer un effet bilame » on entend dans le présent texte le fait que deux matériaux présentant des coefficients de dilatation thermique différents sont agencés de manière solidaire l'un par rapport à l'autre de telle sorte que l'ensemble se déforme en dilatation ou contraction sous l'effet d'un traitement thermique et, éventuellement, d'un champ magnétique si l'un des matériaux est en outre magnétostrictif.

Selon les modes de réalisation décrits plus bas, les deux matériaux peuvent se présenter sous la forme de deux lames accolées solidaires l'une de l'autre, l'interface entre les deux matériaux présentant une surface sensiblement perpendiculaire à la surface du substrat.

Par extension, on entend aussi par « bilame » tout agencement de deux ou plus de deux matériaux présentant des coefficients de dilatation différents, sous forme de multi-lames accolées les unes aux autres de façon solidaire et dont les interfaces entre chacun des matériaux se présenteraient sous la forme d'une surface sensiblement perpendiculaire à la surface du substrat.

Cette définition inclut donc notamment un trilame composé par exemple d'une lame centrale de silicium entourée respectivement d'une lame d'un matériau à CTE positif et d'une lame d'un matériau à CTE négatif.

Selon un mode de réalisation de l'invention, les parois des cellules sont des bilames formés d'un premier et d'un deuxième matériau qui présentent des coefficients de dilatation thermique qui diffèrent d'un rapport d'au moins 2.

Par exemple, la structure génératrice de contraintes comprend des bilames formés des couples de matériaux suivants : Si/Ag, Si/Al, Si/Cu, Si/SiO₂ Ge/Ag, Ge/Al, Ge/Cu, Ge/Fe, Ge/SiO₂, saphir/Ag, saphir/Al, saphir/Cu, et/ou saphir/SiO₂

Selon un autre mode de réalisation, les parois des cellules sont des bilames formés d'un premier et d'un deuxième matériau dont l'un présente un coefficient de dilatation thermique positif et l'autre un coefficient de dilatation thermique négatif.

Par exemple, lesdits bilames sont formés des couples de matériaux suivants : Si/ZrW₂O₈, Cu/ZrW₂O₈, Al/ZrW₂O₈, et/ou Ag/ ZrW₂O₈.

Selon un autre mode de réalisation, le premier et le deuxième matériau du bilame sont séparés par du vide ou par une lame d'un troisième matériau, en particulier le bilame est formé par le couple Ag/ZrW₂O₈ et la lame du troisième matériau est du silicium.

De manière particulièrement avantageuse, le traitement thermique de l'étape (ii) est appliqué à une température comprise entre 20 et 500°C.

Selon une forme d'exécution particulièrement avantageuse de l'invention, la structure génératrice de contraintes est en outre adaptée pour se dilater ou se contracter dans un plan parallèle à la surface du substrat sous l'action d'un champ magnétique.

A cet effet, ladite structure génératrice de contraintes est une structure cellulaire dont les parois des cellules sont perpendiculaires à la surface du substrat et sont composées d'au moins deux matériaux présentant des coefficients de dilatation thermique différents agencés pour permettre une déformation desdites parois sous l'effet dudit traitement thermique, et l'un desdits matériaux est un matériau magnétostrictif.

De manière préférée, le matériau magnétostrictif est un alliage de terre rare et de fer, tel que Terfenol-D, SmFe₂, DyFe₂ ou TbFe₂, et l'autre matériau est du silicium, du SiC ou du germanium.

Dans ce cas, le traitement thermique est préférentiellement appliqué à une température inférieure à la température de Curie du matériau magnétostrictif et l'on applique en outre à ladite structure génératrice de contraintes un champ magnétique adapté pour provoquer une élongation ou une rétraction dudit matériau magnétostrictif.

Si le substrat présente une forme allongée, le champ magnétique appliqué est de préférence statique et orienté parallèlement à la plus grande dimension du substrat.

Si le substrat présente une forme de disque, le champ magnétique appliqué est tournant de manière à provoquer une dilatation ou une contraction de la structure selon deux directions perpendiculaires dans un plan parallèle à la surface du substrat.

Selon un mode particulier de réalisation de l'invention, la structure génératrice de contraintes est rendue solidaire de la surface du substrat par une couche de collage.

La structure génératrice de contraintes peut être fabriquée avant d'être rendue solidaire du substrat par gravure de tranchées dans une couche du premier matériau, remplissage desdites tranchées par le deuxième matériau, masquage des portions de la couche du premier matériau destinées à la formation du bilame et gravure sélective de ladite couche pour retirer les portions non masquées du premier matériau.

De manière alternative, la structure génératrice de contraintes est rendue solidaire du substrat par dépôt d'une couche du premier matériau sur la surface du substrat, suivi par la gravure des tranchées dans ladite couche, remplissage desdites tranchées par le deuxième matériau, masquage des portions de la couche du premier matériau destinées à la formation du bilame et gravure sélective de ladite couche pour retirer les portions non masquées du premier matériau.

L'épaisseur de la couche détachée du substrat est comprise entre 1 et 100 micromètres, de préférence entre 30 et 70 micromètres, de préférence environ 50 micromètres.

Il existe typiquement un rapport compris entre 0,1 et 10 entre l'épaisseur de la couche à détacher et l'épaisseur de la structure génératrice de contraintes.

Selon un mode particulier de réalisation, on forme dans le substrat, avant l'étape (ii), une zone fragile de manière à procurer le clivage selon ladite zone fragile.

Par exemple, ladite zone fragile est formée par implantation d'espèces ioniques dans le substrat à la profondeur du plan de clivage, avec une dose comprise entre 5.10¹⁵ et 10¹⁶ atomes/cm²_{.}

De manière alternative, le substrat et la couche à détacher sont en silicium et la zone fragile est une couche de SiₓGe₁₋ₓ avec 0<x<0,8 dans laquelle la proportion de germanium évolue graduellement entre une valeur minimale aux interfaces et une valeur maximale au centre.

Selon une variante de réalisation, on réalise, avant l'étape (ii), une amorce de rupture dans le substrat à la profondeur du plan de clivage.

Avant l'étape (i), on peut former dans ou sur la couche à détacher du substrat des dispositifs électroniques pour applications optoélectroniques et/ou photovoltaïques, et/ou de puissance et/ou des circuits électroniques et/ou des microsystèmes.

La structure génératrice de contraintes peut être retirée de la couche après que celle-ci a été détachée du substrat.

Par exemple, la structure génératrice de contraintes peut être recyclée après son retrait de la couche détachée en vue d'une nouvelle utilisation pour cliver un substrat.

Le substrat est typiquement en un matériau semi-conducteur.

Selon une forme d'exécution particulière de l'invention, le substrat est un lingot d'un matériau semi-conducteur et l'on applique les étapes (i) et (ii) à plusieurs reprises pour détacher successivement une pluralité de couches dudit substrat.

Un autre objet de l'invention concerne un ensemble comprenant un substrat et une structure dite génératrice de contraintes solidaire de la surface dudit substrat, caractérisé en ce que ladite structure génératrice de contraintes est une structure cellulaire dont les parois des cellules sont perpendiculaires à la surface du substrat et sont composées d'au moins deux matériaux présentant des coefficients de dilatation thermique différents agencés pour permettre une déformation desdites parois sous l'effet d'un traitement thermique.

Enfin, un autre objet de l'invention concerne un dispositif semi-conducteur pour applications photovoltaïques, optoélectroniques ou en électronique, comprenant une couche en matériau semi-conducteur et un support qui est une structure cellulaire, solidaire de la surface de ladite couche, dont les parois des cellules sont perpendiculaires à la surface de la couche et sont composées d'au moins deux matériaux présentant des coefficients de dilatation thermique différents agencés pour permettre une déformation desdites parois sous l'effet d'un traitement thermique.

### BREVE DESCRIPTION DES DESSINS

D'autres caractéristiques et avantages de l'invention ressortiront de la description détaillée qui va suivre, en référence aux dessins annexés sur lesquels :
- la figure 1 est une vue en coupe d'un substrat et d'une structure génératrice de contrainte selon l'invention,
- la figure 2 est une vue en coupe du substrat de la figure 1 clivé et de ladite structure,
- la figure 3 est une vue de dessus d'un mode particulier de l'invention, dans lequel la structure est formée d'une pluralité de cellules dont les parois sont des bilames,
- les figures 4A à 4E illustrent des étapes du procédé de réalisation de la structure de la figure 3,
- la figure 5 est une vue en coupe schématisant l'application d'un champ magnétique à la structure génératrice de contraintes,
- la figure 6 est une vue en coupe d'un mode de réalisation de l'invention dans lequel le substrat à cliver a été pré-fragilisé,
- la figure 7 est une vue en coupe d'une variante dans laquelle une amorce de rupture a été réalisée dans le substrat à cliver.

Pour faciliter l'illustration, les rapports d'épaisseurs des différentes couches n'ont pas nécessairement été respectés.

### DESCRIPTION DETAILLEE DE L'INVENTION

### Procédé de clivage

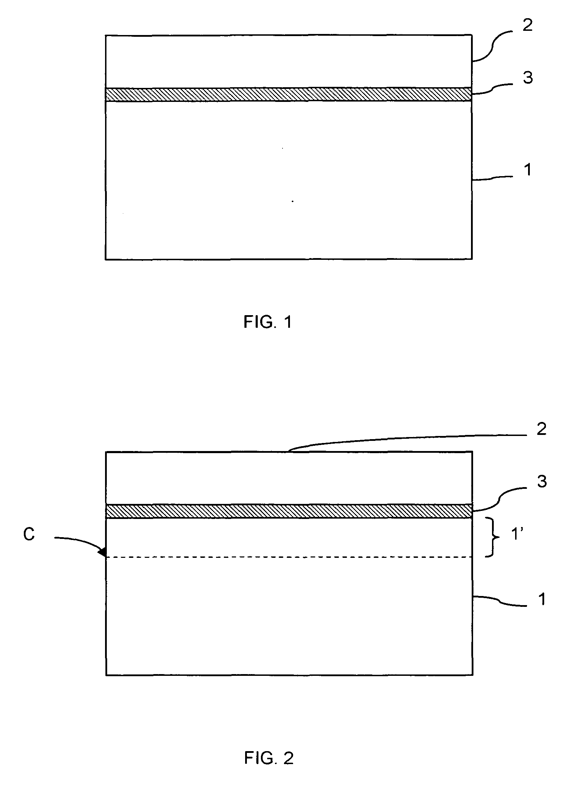

En référence à la figure 1, on forme sur la surface du substrat 1 une structure 2 adaptée pour se déformer sous l'application d'un traitement thermique.

Le substrat peut être tout matériau (semi conducteur, métal, etc.), quelle que soit sa structure cristalline (monocristallin, poly-cristallin, amorphe).

De manière préférée, le substrat est en un matériau semi-conducteur tel que Si, SiC, Ge, un substrat de type IV, II/VI ou III/V tel que GaN, InGaN, AsGa, InP et autres alliages binaires, ternaires, quaternaires de ces éléments.

Selon un mode particulier de réalisation, la couche qui doit être détachée du substrat est une couche active formée d'une pluralité de matériaux semi-conducteurs superposés et/ou elle comprend des dispositifs électroniques pour applications optoélectroniques (par exemple, LED, laser) et/ou photovoltaïques (tels que des cellules multi-jonctions pour le terrestre et le spatial) ; elle peut également comprendre des circuits électroniques, en particulier pour des applications de puissance, et/ou des microsystèmes.

Lesdits dispositifs sont formés dans ou sur la couche à détacher avant la solidarisation du substrat avec la structure génératrice de contraintes.

Cette structure doit être solidaire de la surface du substrat pour lui transmettre les contraintes qui vont conduire au clivage du substrat.

On choisit donc un mode de liaison adapté entre la structure et le substrat.

Selon les matériaux en présence, on peut procéder à un collage par adhésion moléculaire, par brasage, ou par un adhésif approprié, présentant notamment une bonne tenue à la température du traitement thermique qui va être mis en oeuvre pour conduire au clivage du substrat.

Lorsque la structure doit être retirée de la couche qui sera détachée du substrat, il est préférable de prévoir un adhésif permettant un collage réversible, c'est-à-dire qui permettra un démontage de la structure de manière non destructive.

Par exemple, l'adhésif employé est une colle époxy.

Une telle colle présente l'avantage d'être hydrolysable ; elle peut donc être éliminée par action de la vapeur d'eau à 100°C.

Dans le mode de réalisation illustré à la figure 1, la structure 2 est rendue solidaire de la surface du substrat 1 au moyen d'une couche de collage 3.

Cependant, la couche de collage est optionnelle et, en fonction des matériaux considérés, on pourra procéder à un collage par adhésion moléculaire en mettant directement en contact la structure génératrice de contraintes avec la surface du substrat.

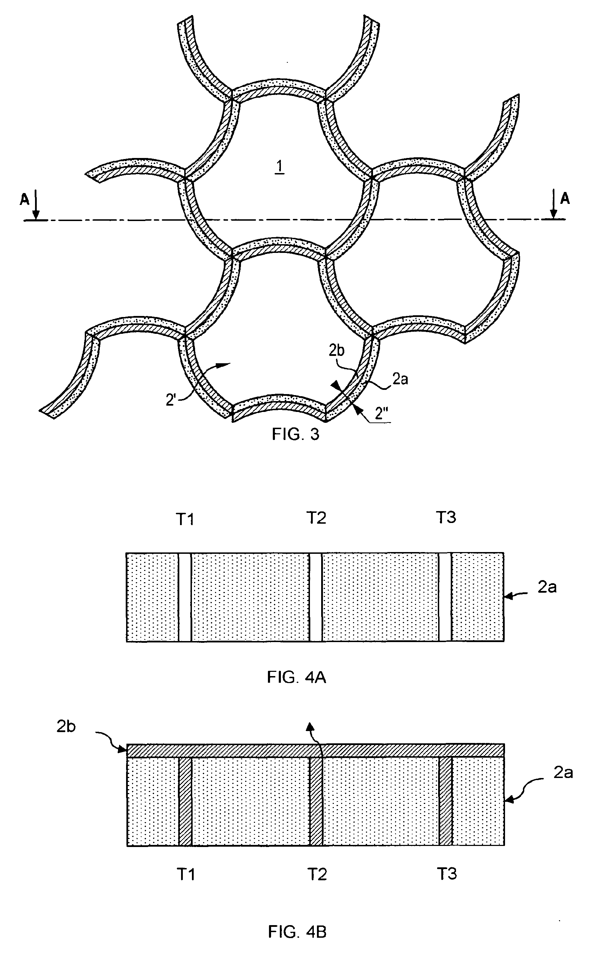

La structure 2 est une structure cellulaire telle qu'illustrée par exemple à la figure 3, et dont un procédé de réalisation sera exposé en détail plus bas.

Les parois 2" des cellules 2' sont constituées par des bilames (voire des trilames) de matériaux présentant des coefficients de dilatation thermique significativement différents, lesdites parois étant perpendiculaires à la surface du substrat.

Par « significativement différent », on entend qu'il existe par exemple un rapport d'environ 2 ou plus entre les coefficients de dilatation thermique des deux matériaux, ou que les coefficients de dilatation thermique des dits matériaux sont de signes opposés.

L'interface entre la structure génératrice de contraintes et le substrat est limitée aux régions où les parois des cellules sont en contact avec le substrat, de sorte que la structure génératrice de contraintes est solidaire localement du substrat.

Pour provoquer le clivage du substrat, on applique un traitement thermique à une température adaptée pour provoquer une déformation de la structure 2 dans les deux dimensions d'un plan parallèle à la surface du substrat 1.

En raison de la géométrie de la structure cellulaire qui lui procure un coefficient de dilatation thermique très élevé, une température comprise entre 20 et 500°C est généralement suffisante pour provoquer la déformation de la structure.

La température est également choisie en fonction de la nature de l'éventuel adhésif permettant la solidarisation de la structure au substrat, afin de ne pas le dégrader.

Ainsi, dans le cas où l'adhésif est une colle époxy, on applique de préférence une température inférieure à 300°C.

La structure 2 étant solidaire du substrat 1, cette déformation engendre dans le substrat une contrainte supérieure à la résistance mécanique du matériau du substrat, ce qui conduit à son clivage selon un plan C, parallèle à la surface du substrat, situé à une certaine profondeur.

Plus le substrat est mince, plus il est souple et plus le clivage a lieu en profondeur dans le substrat.

En revanche, un substrat plus épais donnera lieu à un clivage moins profond.

Comme on peut le voir à la figure 2, le plan de clivage C définit une couche 1' que l'on pourra ensuite détacher pour un usage ultérieur, en appliquant éventuellement une force mécanique pour l'écarter du reste du substrat.

Une fois la couche 1' détachée, on peut retirer la structure 2 qui a servi au clivage.

Si la structure 2 n'est pas destinée à être réutilisée, elle peut être retirée de manière destructive, par exemple par enlèvement de matière mécanique et/ou chimique.

Cependant, il est également possible que la structure 2 soit destinée à être réutilisée, auquel cas on la retire de la couche 1' de manière non destructive (par exemple par une attaque de l'adhésif utilisé pour coller la structure sur le substrat) et on la prépare (par exemple, par un léger polissage) en vue d'une nouvelle utilisation.

Ceci est avantageux notamment lorsque la structure 2 est onéreuse.

Une autre possibilité est que la structure 2 ne soit pas démontée de la couche 1' que l'on a détachée, en particulier si elle doit remplir une fonction lors de l'utilisation ultérieure de la couche détachée.

Ainsi, par exemple, la structure 2 peut être conservée et servir de support à une couche photovoltaïque, avec l'avantage que sa structure transparente permet d'avoir des contacts électriques sur la face arrière de la couche photovoltaïque.

La structure 2 peut également servir de raidisseur à la couche détachée 1', en particulier lorsque celle-ci présente une épaisseur trop faible pour être autoporteuse (i.e. manipulable isolément), c'est-à-dire typiquement lorsque son épaisseur est inférieure à 50 micromètres.

Le cas échéant, la partie restante du substrat peut être préparée en vue de la solidarisation avec une nouvelle structure génératrice de contraintes pour en détacher une couche supplémentaire.

Le procédé permet ainsi de découper au fur et à mesure un lingot en une pluralité de couches.

Un premier avantage de ce procédé est que la structure employée permet une grande liberté de choix dans la définition de son coefficient de dilatation thermique.

En particulier, les critères de définition du coefficient de dilatation thermique ne sont pas les seuls matériaux employés, mais aussi la forme et la dimension des cellules.

Un deuxième avantage est que la structure employée présente un coefficient de dilatation thermique beaucoup plus élevé que les coefficients de dilatation thermique individuels des matériaux la constituant.

Par ailleurs, un choix judicieux des matériaux et la géométrie de la structure permettent de former, selon les besoins, une structure à coefficient de dilatation thermique positif ou négatif.

Par conséquent, un chauffage à une température plus basse que dans l'art antérieur est suffisant pour engendrer dans le substrat une contrainte plus forte que sa résistance mécanique.

Ainsi, lorsque le substrat est en silicium, il présente, à température ambiante, un caractère fragile et cassant (ou « brittle » selon la terminologie anglo-saxonne).

L'application des contraintes par la structure conduit donc plus facilement au clivage du substrat que s'il était à une température supérieure à 500°C, à partir de laquelle s'opère une transition fragile-ductile du silicium.

Par ailleurs, ce traitement thermique à température plus basse est plus favorable aux éventuels dispositifs qui sont formés dans ou sur la couche détachée, puisqu'il ne risque pas de les endommager ni d'affecter leurs performances.

### Structure cellulaire

Selon un mode de réalisation illustré à la figure 3 en vue de dessus, la structure génératrice de contraintes est une structure cellulaire comprenant une pluralité de cellules 2' dont les parois 2" sont des bilames 2a, 2b perpendiculaires à la surface du substrat 1.

Chaque bilame est constitué d'un premier matériau 2a présentant un premier coefficient de dilatation thermique et d'un deuxième matériau 2b présentant un deuxième coefficient de dilatation thermique significativement différent du premier.

De manière avantageuse, les cellules sont identiques et se répètent selon un motif déterminé dans un plan parallèle à la surface du substrat.

Les cellules 2' présentent une forme adaptée pour pouvoir se déformer selon les deux dimensions dans un plan parallèle à la surface du substrat.

Dans l'exemple illustré à la figure 3, les cellules présentent une forme sensiblement hexagonale, avec des parois successivement concaves et convexes, et où le matériau situé du côté intérieur de la cellule est alternativement le matériau 2a et le matériau 2b.

Cependant, d'autres formes de cellules, telles que octogonales ou autres, peuvent être envisagées sans pour autant sortir du cadre de la présente invention.

Par ailleurs, il est également possible de réaliser les parois des cellules rectilignes, l'effet bilame engendré par le traitement thermique ayant alors pour résultat de les incurver.

Des méthodes mathématiques publiées dans la littérature scientifique permettent de définir la forme et la dimension des cellules.

Un procédé de fabrication d'une telle structure est décrit en référence aux figures 4A à 4E, qui sont des vues selon la coupe A-A présentée à la figure 3.

Dans une première étape, illustrée à la figure 4A, on part d'une couche du premier matériau 2a.

Par exemple, ladite couche est une couche de silicium de 50 µm d'épaisseur.

On pratique dans cette couche une gravure profonde pour créer des tranchées T1, T2, T3 dont le parcours définit les parois des cellules.

La forme et les dimensions des cellules auront été définies au préalable en fonction des propriétés de dilatation thermique requises.

On pourra se baser à cet effet sur les publications de R. Lakes, "Cellular solid structures with unbounded thermal expansion", Journal of Material Science Letters, 15, 475-477 (1996) et de T.E. Bruns et O. Sigmund, "Toward the topology design of mechanisms that exhibit snap-through behavior", Computer Methods in Applied Mechanics and Engineering, Vol. 193, Issues 36-38, 10 Sept. 2004, pp 3973-4000.

La largeur des tranchées est par exemple de 10 µm.

Dans une deuxième étape, illustrée à la figure 4B, on effectue un dépôt du deuxième matériau 2b après avoir déposé par évaporation sous vide ou pulvérisation cathodique sur les parois des tranchées une couche de métal dit d'accrochage (par exemple une dizaine de nm de titane).

Par exemple, le deuxième matériau est un métal (tel que de l'aluminium ou de l'argent) qui présente un coefficient de dilatation thermique supérieur à celui du silicium.

Cette opération de dépôt a pour effet de remplir les tranchées T1, T2, T3 du deuxième matériau 2b et également de recouvrir la surface du premier matériau 2a d'une couche du deuxième matériau 2b.

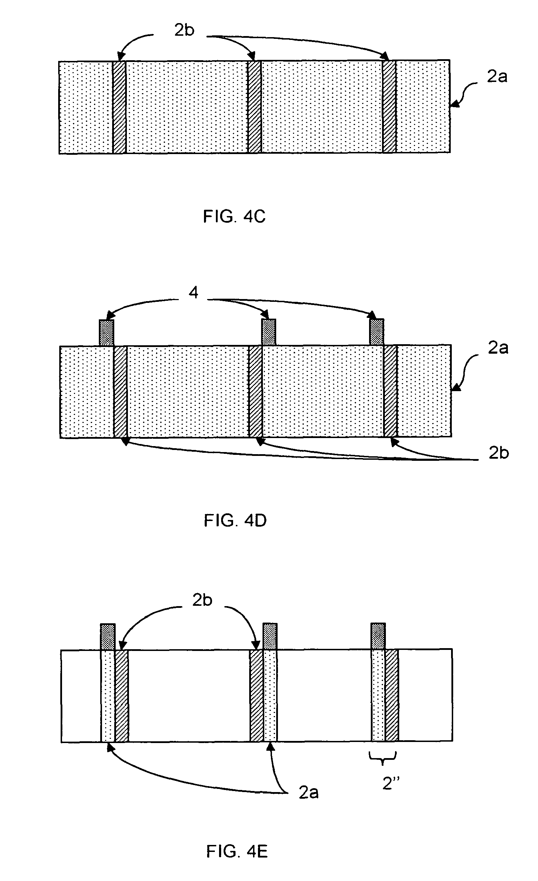

Dans une troisième étape, illustrée à la figure 4C, on retire l'excédent du deuxième matériau qui recouvre la surface du premier matériau 2a par un polissage mécano-chimique (connu sous l'acronyme CMP correspondant au terme anglo-saxon « Chemical-Mechanical Polishing »).

On effectue éventuellement à ce stade un recuit thermique à basse température (c'est-à-dire typiquement de l'ordre de 200°C pour de l'aluminium) sous atmosphère neutre pour densifier le métal ainsi déposé.

Ensuite, en référence à la figure 4D, on dépose un masque de résine 4 sur la couche du premier matériau 2a.

Ce masque est déposé de manière sélective de manière à recouvrir les portions du premier matériau 2a que l'on souhaite conserver dans la structure cellulaire finale 2.

Lesdites portions sont adjacentes aux tranchées remplies du deuxième matériau 2b, afin de constituer avec celles-ci des bilames.

Leur largeur est typiquement de l'ordre de 10 µm.

Le masque de résine est destiné à protéger le premier matériau 2a adjacent au deuxième matériau 2b pendant l'étape de gravure qui va suivre.

En référence à la figure 4E, on procède à une gravure du premier matériau 2a non protégé par le masque 4, ladite gravure étant sélective par rapport au deuxième matériau 2b.

Dans une étape ultérieure, non illustrée ici, on retire le masque 4.

On obtient donc une structure cellulaire constituée d'une pluralité de cellules 2' dont les parois 2" sont des bilames 2a, 2b.

Ladite structure est alors rendue solidaire de la surface du substrat 1 par toute méthode de collage appropriée.

Dans le cas qui vient d'être décrit, la structure est fabriquée indépendamment du substrat puis rendue solidaire de celui-ci.

Il serait cependant également possible de coller ou déposer sur la surface du substrat la couche du premier matériau 2a, et d'appliquer à cette couche un procédé similaire à celui qui vient d'être décrit pour fabriquer la structure cellulaire.

Ainsi, la couche du premier matériau 2a peut être déposée sur la surface du substrat 1 par pulvérisation (ou « sputtering » selon la terminologie anglo-saxonne), ou, de préférence, par dépôt chimique en phase vapeur (ou CVD, acronyme du terme anglo-saxon « Chemical Vapor Déposition ») ou par une méthode électrochimique, avant de procéder à la gravure qui permettra de former la structure cellulaire.

Préalablement au collage de la structure cellulaire ou au dépôt du premier matériau 2a à partir duquel sera formée la structure cellulaire, il est avantageux de préparer la surface du substrat en vue de favoriser la solidarisation avec la structure génératrice de contraintes et/ou de le protéger d'une éventuelle contamination par les matériaux constituant la structure génératrice de contraintes.

Par exemple, on peut former une couche protectrice en oxyde de silicium présentant une épaisseur de l'ordre de 500 nanomètres, déposée par une technique CVD ou bien formée par oxydation thermique si le substrat est en silicium.

Il est également possible de former une couche d'accrochage de titane par une étape d'évaporation dite « flash » sur une épaisseur de 100 à 300 Angstrôms sur ladite couche d'oxyde pour favoriser la solidarisation avec le métal de la structure génératrice de contraintes.

Par ailleurs, lorsque des dispositifs sont formés dans ou sur la couche à détacher, la surface du substrat n'est plus plane et adaptée à la solidarisation avec la structure génératrice de contraintes.

On dépose alors une couche de SiO₂ en surface jusqu'à dépasser la hauteur des dispositifs, puis on la planarise, par exemple par polissage, en vue de la solidarisation avec la structure génératrice de contraintes.

Après le clivage, il sera possible d'éliminer la couche d'oxyde par gravure, ce qui favorisera le retrait de la structure génératrice de contraintes

La figure 3 illustre une vue de dessus (c'est-à-dire selon une direction perpendiculaire à la surface du substrat 1) de l'ensemble substrat - structure cellulaire obtenu.

Lors de l'application du traitement thermique, le deuxième matériau 2b du bilame s'allonge davantage que le premier matériau, en raison de son coefficient de dilatation thermique plus élevé, ce qui engendre une tension et les parois de chaque cellule 2' se tendent jusqu'à devenir sensiblement rectilignes.

Comme les parois des cellules sont solidaires de la surface du substrat, l'allongement se traduit par l'application d'une contrainte à l'intérieur du substrat, qui conduit à son clivage.

Les contraintes ne sont donc pas transmises de manière continue au substrat, mais de manière localisée par chaque bilame.

En d'autres termes, chaque bilame 2a, 2b exerce une contrainte discrète sur le substrat dont il est solidaire, et l'ensemble des contraintes discrètes ainsi exercées se combinent pour générer une contrainte globale dont l'intensité est supérieure à la résistance mécanique du matériau du substrat dans le plan de clivage C.

### Exemples de couples de matériaux employés

Les matériaux constituant le bilame doivent présenter des coefficients de dilatation les plus éloignés possibles.

Un rapport d'environ 2 ou plus entre les coefficients de dilatation thermique des deux matériaux est souhaitable.

Ainsi, lorsque l'un des matériaux du bilame est du silicium (dont le CTE à 25°C est de l'ordre de 4,6.10⁻⁶ K⁻¹), l'autre matériau est avantageusement choisi parmi l'argent (CTE de l'ordre de 18.10⁻⁶ K⁻¹), l'aluminium (CTE de l'ordre de 23.10⁻⁶ K⁻¹), voire le cuivre (CTE de l'ordre de 16,5.10⁻⁶ K⁻¹)_{.}

Dans ces cas, on obtient une structure dans laquelle le silicium se dilate moins que l'autre matériau.

Il est également possible de concevoir une structure dont le comportement est inversé, en utilisant, pour former le bilame, du silicium et un matériau dont le coefficient de dilatation thermique est sensiblement inférieur à celui du silicium.

C'est le cas en particulier de l'oxyde de silicium (SiO₂) et du nitrure de silicium (SiₓN_{y}).

On peut également utiliser pour l'un des matériaux du bilame, du germanium (CTE de l'ordre de 6,1 10⁻⁶ K⁻¹), et pour l'autre matériau, l'un des métaux mentionnés ci-dessus ou encore du fer (CTE de l'ordre de 11,8 10⁻⁶ K⁻¹).

En variante, on peut choisir du saphir pour l'un des matériaux du bilame, et l'un des métaux évoqués ci-dessus pour l'autre matériau.

Enfin, on peut également employer pour l'un des matériaux du bilame un matériau à coefficient de dilatation thermique négatif (tel que le tungstate de zirconium ZrW₂O₈), associé à un matériau à coefficient de dilatation thermique positif (par exemple de l'argent).

L'avantage d'un tel bilame est qu'il n'est pas nécessaire de le chauffer fortement pour obtenir une déformation importante, ce qui le rend particulièrement approprié pour le clivage du silicium dans une plage de température inférieure à 500°C, dans laquelle il présente un caractère fragile (ou « brittle »).

Il est également possible de réaliser une structure cellulaire dont les parois sont des trilames, dans lesquelles le premier et le deuxième matériau formant le bilame sont respectivement un matériau présentant un coefficient de dilatation thermique positif élevé (tel que de l'argent) et un matériau à coefficient de dilatation thermique négatif, séparés par un troisième matériau tel que du silicium.

Le silicium, qui présente un coefficient de dilatation thermique médian, confère stabilité et tenue mécanique à une telle structure.

De manière alternative, on peut former une structure cellulaire avec des parois tri-lames dans lesquelles le premier et le deuxième matériau formant le bilame sont séparés par une lame de vide.

De telles structures sont décrites dans les publications d'O. Sigmund et S. Torquato, "Composites with extremal thermal expansion coefficients", Appl. Phys. Lett. 69(21), 18 Nov. 1996 et "Design of materials with extreme thermal expansion using a three-phase topology optimization method", J. Mech. Phys. Solids, Vol. 45, No. 6, pp1037-1067, 1997.

### Structure cellulaire magnétostrictive

Selon une variante particulièrement avantageuse de la présente invention, la structure génératrice de contraintes est également adaptée pour se déformer sous l'effet d'un champ magnétique.

A cet effet, l'un des matériaux constituant les bilames est un matériau magnétostrictif tout en présentant un coefficient de dilatation thermique significativement différent de celui de l'autre matériau constituant le bilame.

De préférence, le matériau magnétostrictif est choisi parmi les matériaux présentant un pourcentage d'élongation supérieur à 0,02% en valeur absolue et de préférence un matériau dont la magnétostriction est « géante » c'est-à-dire présentant un coefficient de magnétostriction supérieur à 50 ppm en valeur absolue.

Les matériaux à base d'alliages de terres rares et de fer sont connus pour présenter de telles propriétés.

Un exemple de matériau magnétostrictif bien adapté pour la mise en oeuvre de l'invention est du Terfenol-D, qui est un alliage de fer et de terres rares, dont la formule est Tb_{0,3}Dy₀,₇Fe₁₉ et qui peut être utilisé sous forme polycristalline ou amorphe.

Le coefficient de magnétostriction est différent pour chaque forme (cristalline ou amorphe) mais reste supérieur à 50 ppm.

Sous sa forme cristalline, son élongation sous l'effet d'un champ magnétique peut atteindre 0,2% et engendrer des champs de contrainte de compression de l'ordre de 1 kN/cm.

D'autres alliages de fer et de terres rares tels que le SmFe₂ au pourcentage d'élongation négatif, le DyFe₂, et le TbFe₂ au pourcentage d'élongation positif, sont également bien adaptés pour la mise en oeuvre de l'invention.

L'autre matériau du bilame est alors typiquement du silicium, du SiC ou du germanium.

La structure cellulaire peut être fabriquée par le même procédé que celui décrit plus haut.

A titre d'exemple, on peut former une structure dont les parois sont des bilames silicium-Terfenol-D, où l'épaisseur de la lame de silicium est de 50 micromètres et l'épaisseur de la lame de Terfenol-D est de 15 micromètres.

La structure ainsi constituée est apte à se déformer sous l'effet combiné de la température (qui peut alors être plus basse que dans le cas où l'on n'utilise que le traitement thermique pour provoquer sa déformation) et d'un champ magnétique.

La déformation globale d'une telle structure cellulaire est bien plus importante que la déformation intrinsèque du matériau magnétostrictif sous l'effet du champ magnétique.

Par exemple, l'augmentation relative des dimensions de la structure peut être 10 à 100 fois supérieure à l'allongement relatif du matériau magnétostrictif.

Ce coefficient d'amplification dépend de la conception géométrique des cellules et de leur arrangement en réseau.

Cette amplification permet pour une dilatation ou une contraction déterminée de la structure génératrice de contraintes, l'application d'un traitement thermique plus faible, compatible avec la présence de de dispositifs électroniques très sensibles à la température dans ou sur le substrat, par comparaison au mode de réalisation précédent où la structure ne se dilate ou se contracte que sous l'effet de la température

Pour procurer le clivage du substrat avec une telle structure, on applique simultanément un traitement thermique et un champ magnétique.

La température appliquée doit rester significativement inférieure à la température de Curie Tc du matériau magnétostrictif, de sorte à ne pas altérer les propriétés magnétiques de la structure génératrice de contraintes.

Pour le Terfenol-D, la température de Curie est de 380°C, si bien que le traitement thermique ne sera pas appliqué à une température de plus de 350°C, et de préférence, sera appliqué à une température inférieure à 300°C.

En ce qui concerne le DyFe₂, le SmFe₂ et le TbFe₂, la température de Curie se situe entre 630 et 710°C ; le traitement thermique sera donc appliqué à une température de préférence inférieure à 600°C.

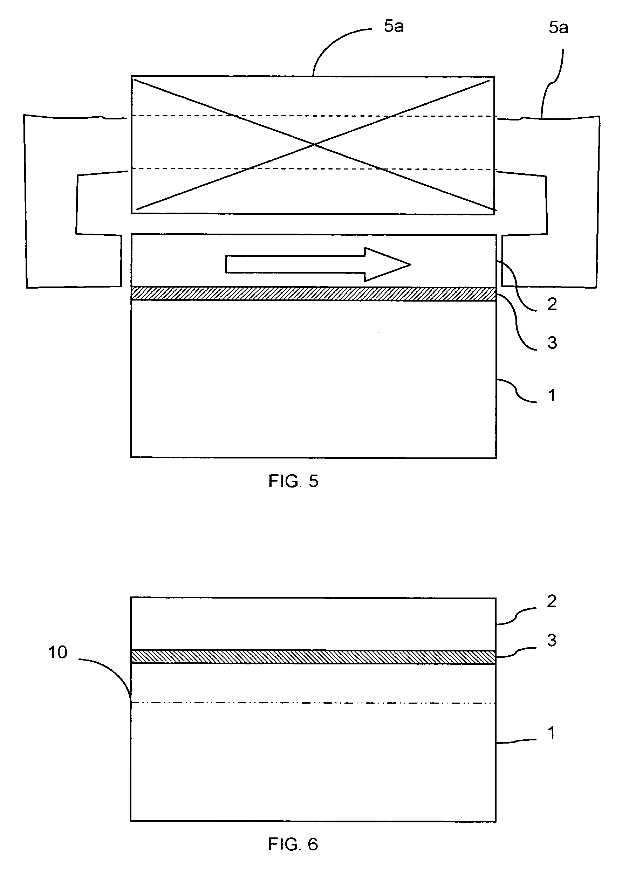

En référence à la figure 5, on applique le champ magnétique au moyen d'un circuit magnétique 5a entourant la structure génératrice de contraintes 2, ledit circuit magnétique étant entouré par une bobine conductrice 5b.

Comme représenté par la flèche horizontale, ce dispositif génère une induction parallèle à la surface du substrat.

Dans le cas où le substrat présente une forme allongée, c'est-à-dire qu'il existe un rapport d'au moins 10 entre les dimensions du substrat selon deux directions perpendiculaires dans un plan parallèle à sa surface (le substrat pouvant alors être considéré comme monodimensionnel), le champ magnétique appliqué est de préférence statique et orienté parallèlement à la plus grande dimension du substrat.

Dans le cas où les dimensions du substrat selon deux directions perpendiculaires dans un plan parallèle à sa surface sont du même ordre de grandeur (par exemple, lorsque le substrat présente la forme d'un disque), le champ magnétique est appliqué sous la forme d'une combinaison de champs variables créant une induction tournante dans le plan du substrat, afin de provoquer une dilatation dans les deux dimensions de la structure génératrice de contraintes.

L'induction magnétique nécessaire est typiquement comprise entre 0,1 et 1 Tesla.

Un avantage du traitement magnétique est qu'il peut être réalisé sans contact avec la structure génératrice de contraintes ni le substrat à cliver, ce qui facilite sa mise en oeuvre.

### Pré-fragilisation du substrat

Selon un mode de réalisation particulier de l'invention, le substrat peut être fragilisé avant l'application du traitement thermique (et, le cas échéant, du champ magnétique), en vue de faciliter son clivage.

Comme illustré à la figure 6, on forme une zone fragile 10 dans le substrat dans un plan correspondant au plan de clivage.

La fragilisation peut résulter d'une implantation d'espèces ioniques combinée ou non avec des traitements thermiques, pouvant résulter en la création de pores et/ou de microbulles dans un plan correspondant au plan de clivage.

Dans ce cas, la dose d'espèce implantée est environ inférieure d'un facteur 10 à celle nécessaire pour une fracture selon la technologie Smart Cut™.

Par exemple, la dose d'implantation d'ions H+ pour une fracture par Smart Cut™ à 20 micromètres de profondeur dans le silicium est approximativement de 10¹⁷ atomes/cm², tandis que la dose nécessaire pour une pré-fragilisation selon l'invention est de l'ordre de 5.10¹⁵ à 10¹⁶ atomes/cm²_{.}

Ledit traitement de fragilisation peut être aussi réalisé pendant l'élaboration du substrat.

Ainsi, par exemple, une zone de fragilisation peut être constituée par une couche épitaxiée de 2 µm d'épaisseur de Siₓ-Ge₁₋ₓ (où 0<x<0,8) sur un substrat de silicium, cette couche présentant un pourcentage de germanium maximum (jusqu'à 20%) au centre de la couche et décroissant jusqu'à environ 5% quand on se rapproche des interfaces inférieures et supérieures.

On fait croître par épitaxie sur ladite couche une autre couche de silicium de 20 µm par exemple.

Le gradient de germanium dans la couche de Siₓ-Ge₁₋ₓ est choisi pour permettre une croissance épitaxiale avec une qualité cristalline suffisante (i.e. faible densité de dislocations, absence de fissure) de la couche sus-jacente de Si qui est destinée à être détachée ultérieurement.

Ce gradient de concentration permet en effet une adaptation en continu du paramètre de maille du Siₓ-Ge₁₋ₓ à celui du silicium sous-jacent sans créer de relâchement de contraintes dans la couche par la formation de dislocations.

La couche de Siₓ-Ge₁₋ₓ est mécaniquement plus fragile que les couches sous- et susjacentes de silicium et le clivage interviendra à son niveau.

### Amorce de rupture dans le substrat

De manière alternative, on peut faciliter le clivage en procurant une amorce de rupture dans le substrat à la profondeur désirée.

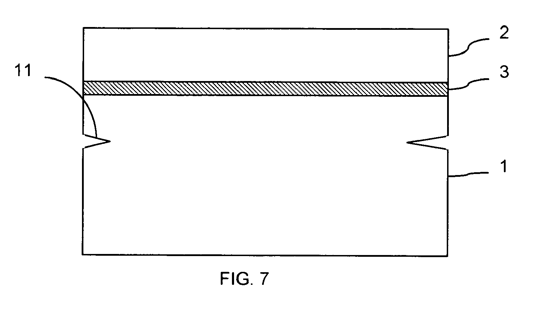

Comme illustré à la figure 7, l'amorce de rupture peut se présenter sous la forme d'une indentation 11 (typiquement, de quelques dizaines de micromètres de profondeur) pratiquée sur une face latérale du substrat 1, à la profondeur correspondant sensiblement à la profondeur à laquelle la structure génératrice de contraintes doit induire la fracture (plan C mentionné ci-dessous).

Une telle amorce permet, dans une plage de profondeur où la contrainte est très élevée, de choisir précisément la localisation de la rupture dans le substrat.

Elle permet également de diminuer le champ de contrainte à appliquer pour le clivage et donc la température et, le cas échéant, l'induction magnétique.

L'amorce de rupture peut être réalisée de manière mécanique, à l'aide d'un outil tranchant, et/ou chimique.

Par exemple, pour une plaquette de silicium de type N comportant une couche de silicium dopée P+ d'une épaisseur d'environ 2 microns, qui correspond à la profondeur souhaitée de fracture, on effectue une attaque sélective au pyrocatéchol à la périphérie de la couche de silicium dopée P+ pour former une entaille.

La profondeur de cette entaille dépend de la durée de l'attaque chimique.

Typiquement, pour 10 minutes d'attaque dans un bain avec agitation, on peut former une entaille présentant une profondeur d'une cinquantaine de micromètres.

### Exemple de mise en oeuvre

Pour cliver un substrat de silicium, on forme une structure cellulaire telle qu'illustrée en vue de dessus à la figure 3.

Les parois des cellules sont formées d'un bilame silicium 2a / argent 2b.

La largeur des lames de silicium et d'argent est de 10 micromètres environ.

L'épaisseur (selon une direction perpendiculaire à la surface du substrat) de la structure cellulaire est d'environ 40 micromètres.

Chaque cellule est inscrite dans un cercle de 100 micromètres de diamètre, chaque côté de la cellule présentant une longueur d'environ 50 micromètres et étant incurvée avec une flèche d'environ 10 micromètres.

Pour éviter une potentielle contamination du substrat par l'argent du bilame, on forme de préférence une couche protectrice d'oxyde sur la surface du substrat de silicium avant de procéder au collage de la structure sur le substrat, ladite couche d'oxyde pouvant être retirée après le clivage du substrat et le retrait de la structure de la couche détachée.

On colle cette structure cellulaire sur la surface du substrat par un procédé d'adhésion moléculaire susceptible de fournir une densité d'énergie d'adhésion forte dès la température ambiante, par exemple un procédé d'adhésion avec préparation des surfaces par traitement plasma. Il est connu que ce type de traitement permet d'obtenir des densités d'énergie d'adhésion de plusieurs centaines de mJ/m².

Le processus d'adhésion, c'est-à-dire d'augmentation de l'énergie d'adhésion sera réalisé ensuite en augmentant la température de l'ensemble selon une rampe de température en fonction du temps suffisamment lente (typiquement 5°C/mn) pour que le processus d'adhésion soit totalement terminé avant qu'un éventuel effet parasite de déformation de la structure cellulaire ne puisse s'exercer sensiblement sur l'interface de collage..

On chauffe ensuite l'ensemble à une température d'environ 450°C.

Cette température est suffisamment modérée pour que l'argent du bilame ne contamine pas le substrat à travers la couche protectrice susmentionnée.

Sous l'effet de ce chauffage, la lame d'argent s'allonge davantage que la lame de silicium, ce qui conduit les parois incurvées à se tendre jusqu'à obtenir des parois sensiblement rectilignes.

Cette déformation génère dans le substrat de silicium une contrainte qui permet de le cliver à une profondeur comprise entre 50 et 100 micromètres.

De manière alternative, la structure cellulaire peut être fabriquée avec des parois rectilignes pour chaque cellule, lesdites parois étant amenées à s'incurver sous l'effet du traitement thermique.

## Revendications

1. Procédé de clivage d'un substrat (1) en vue d'en détacher une couche (1'), comprenant les étapes successives suivantes :
(i) la formation d'une structure (2) dite génératrice de contraintes, solidaire localement de la surface du substrat (1), ladite structure génératrice de contraintes (2) étant une structure cellulaire dont les parois (2") des cellules (2') sont perpendiculaires à la surface du substrat et sont composées d'au moins deux matériaux (2a, 2b) présentant des coefficients de dilatation thermique différents agencés pour permettre une déformation desdites parois sous l'effet d'un traitement thermique, de sorte que ladite structure est adaptée pour se dilater ou se contracter dans un plan parallèle à la surface du substrat (1) sous l'effet dudit traitement thermique,
(ii) l'application à ladite structure d'un traitement thermique adapté pour provoquer la dilatation ou la contraction de ladite structure (2) de manière à générer dans le substrat (1) une pluralité de contraintes locales dont la combinaison génère une contrainte supérieure à la résistance mécanique du substrat dans un plan de clivage (C) parallèle à la surface du substrat définissant la couche (1') à détacher, ladite contrainte conduisant au clivage du substrat (1) selon ledit plan (C).

2. Procédé selon la revendication 1, **caractérisé en ce que** les parois (2") des cellules (2') sont des bilames formés d'un premier et d'un deuxième matériau (2a, 2b) qui présentent des coefficients de dilatation thermique qui diffèrent d'un rapport d'au moins 2, tels que des bilames formés des couples de matériaux suivants : Si/Ag, Si/Al, Si/Cu, Si/SiO₂, Ge/Ag, Ge/Al, Ge/Cu, Ge/Fe, Ge/SiO₂, saphir/Ag, saphir/Al, saphir/Cu, et/ou saphir/SiO₂.

3. Procédé selon la revendication 1, **caractérisé en ce que** les parois (2") des cellules (2') sont des bilames formés d'un premier et d'un deuxième matériau (2a, 2b) dont l'un présente un coefficient de dilatation thermique positif et l'autre un coefficient de dilatation thermique négatif, tels que des bilames formés des couples de matériaux suivants : Si/ZrW₂O₈, Cu/ZrW₂O₈, Al/ZrW₂O₈, et/ou Ag/ ZrW₂O₈.

4. Procédé selon l'une des revendications 1 à 3, **caractérisé en ce que** le premier et le deuxième matériau du bilame sont séparés par du vide ou par une lame d'un troisième matériau, en particulier le bilame est formé par le couple Ag/ZrW₂O₈ et la lame du troisième matériau est du silicium.

5. Procédé selon l'une des revendications 1 à 4, **caractérisé en ce que** le traitement thermique est appliqué à une température comprise entre 20 et 500°C.

6. Procédé selon la revendication 1, **caractérisé en ce que** la structure génératrice de contraintes (2) est en outre adaptée pour se dilater ou se contracter sous l'action d'un champ magnétique, ladite structure génératrice de contraintes (2) étant une structure cellulaire dont les parois (2") des cellules (2') sont perpendiculaires à la surface du substrat et sont composées d'au moins deux matériaux (2a, 2b) présentant des coefficients de dilatation thermique différents agencés pour permettre une déformation desdites parois sous l'effet dudit traitement thermique, l'un desdits matériaux étant un matériau magnétostrictif.

7. Procédé selon la revendication 6, **caractérisé en ce que** le matériau magnétostrictif est un alliage de terre rare et de fer, tel que Terfenol-D, SmFe₂, DyFe₂ ou TbFe₂, et **en ce que** l'autre matériau est du silicium, du SiC ou du germanium.

8. Procédé selon l'une des revendications 6 ou 7, **caractérisé en ce que** le traitement thermique est appliqué à une température inférieure à la température de Curie du matériau magnétostrictif et **en ce que** l'on applique en outre à ladite structure un champ magnétique adapté pour provoquer une élongation ou une rétraction dudit matériau magnétostrictif.

9. Procédé selon l'une des revendications 1 à 8, **caractérisé en ce que** la structure génératrice de contraintes (2) est rendue solidaire de la surface du substrat (1) par une couche de collage (3).

10. Procédé selon l'une des revendications 1 à 9, **caractérisé en ce que** la structure génératrice de contraintes (2) est fabriquée par gravure de tranchées dans une couche du premier matériau (2a), remplissage desdites tranchées par le deuxième matériau (2b), masquage des portions de la couche du premier matériau (2a) destinées à la formation du bilame et gravure sélective de ladite couche pour retirer les portions non masquées du premier matériau (2a).

11. Procédé selon l'une des revendications 1 à 10, **caractérisé en ce que** l'épaisseur de la couche (1') détachée du substrat (1) est comprise entre 1 et 100 micromètres, de préférence entre 30 et 70 micromètres, de préférence environ 50 micromètres.

12. Procédé selon l'une des revendications 1 à 11, **caractérisé en ce qu'**il existe un rapport compris entre 0,1 et 10 entre l'épaisseur de la couche (1') à détacher et l'épaisseur de la structure (2) génératrice de contraintes.

13. Procédé selon l'une des revendications 1 à 12, **caractérisé en ce qu'**avant l'étape (ii) on forme dans le substrat (1) une zone fragile (10) de manière à procurer le clivage selon ladite zone fragile (10).

14. Procédé selon l'une des revendications 1 à 12, **caractérisé en ce qu'**avant l'étape (ii) on réalise une amorce de rupture (11) dans le substrat (1) à la profondeur du plan de clivage (C).

15. Procédé selon l'une des revendications 1 à 14, **caractérisé en ce qu'**avant l'étape (i) on forme dans ou sur la couche (1') à détacher du substrat (1) des dispositifs électroniques pour applications optoélectroniques et/ou photovoltaïques, et/ou de puissance et/ou des circuits électroniques et/ou des microsystèmes.

16. Procédé selon l'une des revendications 1 à 15, **caractérisé en ce que** la structure génératrice de contraintes (2) est retirée de la couche (1') après son détachement du substrat (1), par exemple pour être recyclée après son retrait de la couche détachée (1') en vue d'une nouvelle utilisation pour cliver un substrat.

17. Procédé selon l'une des revendications 1 à 16, **caractérisé en ce que** le substrat (1) est un lingot d'un matériau semi-conducteur et **en ce que** l'on applique les étapes (i) et (ii) à plusieurs reprises pour détacher successivement une pluralité de couches (1') dudit substrat (1).

18. Ensemble comprenant un substrat (1) et une structure (2) dite génératrice de contraintes solidaire de la surface dudit substrat (1), **caractérisé en ce que** ladite structure génératrice de contraintes (2) est une structure cellulaire dont les parois (2") des cellules (2') sont perpendiculaires à la surface du substrat (1) et sont composées d'au moins deux matériaux (2a, 2b) présentant des coefficients de dilatation thermique différents agencés pour permettre une déformation desdites parois sous l'effet d'un traitement thermique..

19. Dispositif semi-conducteur pour applications photovoltaïques, optoélectroniques ou en électronique, comprenant une couche (1') en matériau semi-conducteur et un support (2) qui est une structure cellulaire solidaire de la surface de ladite couche, dont les parois (2") des cellules (2') sont perpendiculaires à la surface de la couche (1') et sont composées d'au moins deux matériaux (2a, 2b) présentant des coefficients de dilatation thermique différents agencés pour permettre une déformation desdites parois sous l'effet d'un traitement thermique.

## Patentansprüche

1. Verfahren zur Aufspaltung eines Substrats (1) zum Ablösen einer Schicht (1'), wobei das Verfahren die folgenden Schritte aufweist:
(i) Ausbilden eines spannungserzeugenden Aufbaus (2), der lokal mit der Fläche des Substrats (1) verbunden ist, wobei der spannungserzeugende Aufbau (2) ein Zellen (2') aufweisender Aufbau ist, deren Wände (2") senkrecht auf einer Fläche des Substrats stehen und aus zumindest zwei Materialien (2a, 2b) mit unterschiedlichen Wärmeausdehnungskoeffizienten zusammengesetzt sind, die eingerichtet sind, eine Verformung unter der Einwirkung einer Wärmebehandlung zu ermöglichen, so dass der Aufbau angepasst ist, sich in einer parallel zu der Fläche des Substrats (1) verlaufenden Ebene unter der Einwirkung der Wärmebehandlung auszudehnen oder zusammenzuziehen,
(ii) Ausführen einer Wärmebehandlung an dem Aufbau, wobei die Wärmebehandlung angepasst ist, die Ausdehnung oder das Zusammenziehen des Aufbaus (2) derart herbeizuführen, dass in dem Aufbau (1) eine Vielzahl von lokalen Spannungen erzeugt wird, deren Kombination eine Spannung erzeugt, die größer ist als der mechanische Widerstand des Aufbaus in einer Aufspaltungsebene (C), die parallel zu der Fläche des Substrats ist und die abzulösende Schicht (1') festlegt, wobei die Spannung zur Aufspaltung des Aufbaus (1) gemäß der Ebene (C) führt.

2. Verfahren gemäß Anspruch 1, **dadurch gekennzeichnet, dass** die Wände (2") der Zellen (2') Bimetallstreifen sind, die aus ersten und zweiten Materialien (2a, 2b) ausgebildet sind, welche Wärmeausdehnungskoeffizienten aufweisen, die sich um ein Verhältnis von zumindest 2 unterscheiden, solche wie Bimetallstreifen, die aus den folgenden Materialpaarungen ausgebildet werden: Si/Ag, Si/Al, Si/Cu, Si/SiO₂, Ge/Ag, Ge/Al, Ge/Cu, Ge/Fe, Ge/SiO₂, Saphir/Ag, Saphir/Al, Saphir/Cu, und/oder Saphir/SiO₂.

3. Verfahren gemäß Anspruch 1, **dadurch gekennzeichnet, dass** die Wände (2) der Zellen (2') Bimetallstreifen sind, die aus ersten und zweiten Materialien (2a, 2b) ausgebildet sind, wobei eines der Materialien einen positiven Wärmeausdehnungskoeffizienten aufweist und das andere der Materialien einen negativen Wärmeausdehnungskoeffizienten aufweist, solche wie Bimetallstreifen, die aus den folgenden Materialpaarungen ausgebildet werden: Si/ZrW₂O₈, Cu/ZrW₂O₈, Al/ZrW₂O₈, und/oder Ag/ZrW₂O₈.

4. Verfahren gemäß einem der Ansprüche 1 bis 3, **dadurch gekennzeichnet, dass** die ersten und zweiten Materialien durch einen Zwischenraum oder durch einen dritten Materialstreifen getrennt sind, wobei der Bimetallstreifen insbesondere aus der Paarung Ag/ZrW₂O₈ ausgebildet ist und der dritte Materialstreifen aus Silizium ausgebildet ist.

5. Verfahren gemäß einem der Ansprüche 1 bis 4, **dadurch gekennzeichnet, dass** die Wärmebehandlung bei einer Temperatur zwischen 20 und 500 °C ausgeführt wird.

6. Verfahren gemäß Anspruch 1, **dadurch gekennzeichnet, dass** der spannungserzeugende Aufbau (2) weiterhin angepasst ist, sich bei Einwirkung eines Magnetfeldes auszudehnen oder zusammenzuziehen, wobei der spannungserzeugende Aufbau (2) ein Zellen (2) aufweisender Aufbau ist, deren Wände (2") senkrecht auf der Fläche des Substrats stehen und aus zumindest zwei Materialien (2a, 2b) mit unterschiedlichen Wärmeausdehnungskoeffizienten zusammengesetzt sind, die eingerichtet sind, eine Verformung der Wände unter Einwirkung der Wärmebehandlung zu ermöglichen, wobei eines der Materialien ein magnetostriktives Material ist.

7. Verfahren gemäß Anspruch 6, **dadurch gekennzeichnet, dass** das magnetostriktive Material eine Legierung aus Metallen der Seltenen Erden oder Eisen ist, solche wie Terfenol-D, SmFe₂, DyFe₂ oder TbFe₂, und dass das andere Material aus Silizium, aus SiC oder aus Germanium ist.

8. Verfahren gemäß einem der Ansprüche 6 oder 7, **dadurch gekennzeichnet, dass** die Wärmebehandlung bei einer Temperatur ausgeführt wird, die kleiner als die Curie-Temperatur des magnetostriktiven Materials ist, und dass weiterhin ein Magnetfeld auf den Aufbau aufgebracht wird, das angepasst ist, eine Dehnung oder ein Zusammenziehen des magnetostriktiven Materials herbeizuführen.

9. Verfahren gemäß einem der Ansprüche 1 bis 8, **dadurch gekennzeichnet, dass** der spannungserzeugende Aufbau (2) fest mit der Fläche des Aufbaus (1) mittels einer Klebschicht (3) verbunden wird.

10. Verfahren gemäß einem der Ansprüche 1 bis 9, **dadurch gekennzeichnet, dass** der spannungserzeugende Aufbau (2) durch Ätzen von Scheiben in einer Schicht aus dem ersten Material (2a), Füllen der Scheiben mit dem zweiten Material (2b), Abdecken von Abschnitten der Schicht aus dem ersten Material (2a), die zur Ausbildung der Bimetallstreifen vorgesehen sind, und selektives Ätzen der Schicht, um die Abschnitte aus dem ersten Material (2a) auszusondern, die nicht mit abgedeckt sind, hergestellt wird.

11. Verfahren gemäß einem der Ansprüche 1 bis 10, **dadurch gekennzeichnet, dass** die Dicke der von dem Aufbau abzulösenden Schicht (1') zwischen 1 und 100 µm, vorzugsweise zwischen 30 und 70 µm, vorzugsweise bei ca. 50 µm liegt.

12. Verfahren gemäß einem der Ansprüche 1 bis 11, **dadurch gekennzeichnet, dass** ein Verhältnis zwischen 0,1 und 10 zwischen der Dicke der abzulösenden Schicht (1') und der Dicke des spannungserzeugenden Aufbaus (2) besteht.

13. Verfahren gemäß einem der Ansprüche 1 bis 12, **dadurch gekennzeichnet, dass** vor dem Schritt (ii) in dem Aufbau (1) ein empfindlicher Bereich (10) ausgebildet wird, um die Aufspaltung entsprechend dem empfindlichen Bereich (10) herbeizuführen.

14. Verfahren gemäß einem der Ansprüche 1 bis 12, **dadurch gekennzeichnet, dass** vor dem Schritt (ii) ein Bruchauslöser (11) in dem Aufbau (1) in einer Tiefe der Aufspaltungsebene (C) realisiert wird.

15. Verfahren gemäß einem der Ansprüche 1 bis 14, **dadurch gekennzeichnet, dass** vor dem Schritt (i) in oder auf der abzulösenden Schicht (1') des Aufbaus (1) elektronische Vorrichtungen für optoelektronische und/oder photovoltaische Anwendungen und/oder Kraftaufbringungen und/oder elektronische Schaltungen und/oder Mikrosysteme ausbildet werden.

16. Verfahren gemäß einem der Ansprüche 1 bis 15, **dadurch gekennzeichnet, dass** der spannungserzeugende Aufbau (2) von der Schicht (1') nach deren Ablösung von dem Substrat (1) ausgesondert wird, beispielweise um nach seiner Entfernung von der abgelösten Schicht (1') im Hinblick auf einen neuen Einsatz zur Aufspaltung eines Substrats wiederverwertet zu werden.

17. Verfahren gemäß einem der Ansprüche 1 bis 16, **dadurch gekennzeichnet, dass** der Aufbau (1) ein Block aus einem Halbleitermaterial ist, und dass die Schritte (i) und (ii) mehrere Male ausgeführt werden, um sukzessive eine Vielzahl von Schichten (1') des Aufbaus (1) abzulösen.

18. Anordnung mit einem Aufbau (1) und einem spannungserzeugenden Aufbau (2), der mit der Fläche des Aufbaus (1) verbunden ist, **dadurch gekennzeichnet, dass** der spannungserzeugende Aufbau (2) ein Zellen (2') aufweisender Aufbau ist, deren Wände (2") senkrecht auf der Fläche des Aufbaus (1) stehen und aus zumindest zwei Materialien (2a, 2b) mit unterschiedlichen Wärmeausdehnungskoeffizienten zusammengesetzt sind, die eingerichtet sind, eine Verformung der Wände unter Einwirkung einer Wärmebehandlung zu ermöglichen.

19. Halbleitervorrichtung für photovoltaische, optoelektronische oder elektronische Anwendungen, mit einer Schicht (1') aus einem Halbleitermaterial und einem Träger (2), der ein Zellen (2') aufweisender und mit der Fläche der Schicht verbundener Aufbau ist, deren Wände (2") senkrecht auf der Fläche der Schicht (1') stehen und zumindest aus zwei Materialien (2a, 2b) mit unterschiedlichen Wärmeausdehnungskoeffizienten zusammengesetzt sind, die eingerichtet sind, eine Verformung der Wände unter Einwirkung einer Wärmebehandlung zu ermöglichen.

## Claims

1. A process for cleaving a substrate (1) for the purpose of detaching a film (1') therefrom, comprising the following successive steps:
(i) forming a stress-generating structure (2), locally bonded to the substrate surface (1), said stress-generating structure (2) being a cellular structure the cell (2') walls (2") of which are perpendicular to the substrate surface and are composed of at least two materials (2a, 2b) having different thermal expansion coefficients designed to allow said walls to deform under the effect of a heat treatment, so that said structure is adapted to expand or contract in a plane parallel to the substrate surface (1) under the effect of said heat treatment,
(ii) applying to said structure a heat treatment designed to cause said structure (2) to expand or contract so as to generate in the substrate (1) a plurality of local stresses which in combination generates a stress greater than the mechanical strength of the substrate in a cleavage plane (C) parallel to the substrate surface defining the film (1') to be detached, with said stress leading to the cleavage of the substrate (1) through said plane (C).

2. The process according to claim 1, **characterized in that** the cell (2') walls (2") are bimaterial strips formed from first and second materials (2a, 2b) that have thermal expansion coefficients differing by a ratio of at least 2, such as bimaterial strips formed from the following pairs of materials: Si/Ag, Si/Al, Si/Cu, Si/SiO₂, Ge/Ag, Ge/Al, Ge/Cu, Ge/Fe, Ge/SiO₂, sapphire/Ag, sapphire/Al, sapphire/Cu, and/or sapphire/SiO₂.

3. The process according to claim 1, **characterized in that** the cell (2') walls (2") are bimaterial strips formed from first and second materials (2a, 2b), one having a positive thermal expansion coefficient and the other a negative thermal expansion coefficient, such as bimaterial strips formed from the following pairs of materials: Si/ZrW₂O₈, Cu/ZrW₂O₈, Al/ZrW₂O₈, and/or Ag/ZrW₂O₈.

4. The process according to one of claims 1 to 3, **characterized in that** the first and second materials of the bimaterial strip are separated by a void or by a strip of a third material, and in particular the bimaterial strip is formed by the pair Ag/ZrW₂O₈ and the strip of the third material is silicon.

5. The process according to one of claims 1 to 4, **characterized in that** the heat treatment is applied at a temperature between 20 and 500 °C.

6. The process according to claim 1, **characterized in that** the stress-generating structure (2) is further designed to expand or contract under the action of a magnetic field, said stress-generating structure (2) being a cellular structure the cell (2') walls (2") of which are perpendicular to the substrate surface and are composed of at least two materials (2a, 2b) having different thermal expansion coefficients designed to allow said walls to deform under the effect of said heat treatment, with one of said materials being a magnetostrictive material.

7. The process according to claim 6, **characterized in that** the magnetostrictive material is a rare-earth/iron alloy, such as Terfenol-D, SmFe₂, DyFe₂ or TbFe₂, and **in that** the other material is silicon, SiC or germanium.

8. The process according to one of claims 6 or 7, **characterized in that** the heat treatment is applied at a temperature below the Curie temperature of the magnetostrictive material and **in that** a magnetic field is also applied to said structure, suitable for causing said magnetostrictive material to elongate or contract.

9. The process according to one of claims 1 to 8, **characterized in that** the stress-generating structure (2) is bonded to the surface of the substrate (1) by a bonding layer (3).

10. The process according to one of claims 1 to 9, **characterized in that** the stress-generating structure (2) is fabricated by etching trenches in a layer of the first material (2a), filling said trenches with the second material (2b), masking portions of the layer of the first material (2a) that are intended to form the bimaterial strip, and selectively etching said layer so as to remove the non-masked portions of the first material (2a).

11. The process according to one of claims 1 to 10, **characterized in that** the thickness of the detached film (1') of the substrate (1) is between 1 and 100 microns, preferably between 30 and 70 microns, preferably about 50 microns.

12. The process according to one of claims 1 to 11, **characterized in that** there is a ratio of between 0.1 and 10 between the thickness of the film (1') to be detached and the thickness of the stress-generating structure (2).

13. The process according to one of claims 1 to 12, **characterized in that** before step (ii) a weakened zone (10) is formed in the substrate (1) so as to cause the cleavage along said weakened zone (10).

14. The process according to one of claims 1 to 12, **characterized in that** before step (ii) a fracture initiator (11) is provided in the substrate (1) at the depth of the cleavage plane (C).

15. The process according to one of claims 1 to 14, **characterized in that** before step (i) electronic devices are formed in or on the film (1') to be detached from the substrate (1), the devices being for optoelectronic and/or photovoltaic or power applications, and/or power devices and/or electronic circuits and/or microsystems.

16. The process according to one of claims 1 to 15, **characterized in that** the stress-generating structure (2) is removed from the film (1') after detachment from the substrate (1), for example to be recycled after removal from the detached film (1') to be used again to cleave a substrate.

17. The process according to one of claims 1 to 16, **characterized in that** the substrate (1) is an ingot of a semiconductor material and **in that** steps (i) and (ii) are applied several times for successively detaching a plurality of films (1') from said substrate (1).

18. An assembly comprising a substrate (1) and a stress-generating structure (2) bonded to the surface of said substrate (1), **characterized in that** said stress-generating structure (2) is a cellular structure the cell (2') walls (2") of which are perpendicular to the surface of the substrate (1) and are composed of at least two materials (2a, 2b) having different thermal expansion coefficients suitable for allowing said walls to deform under the effect of a heat treatment.

19. A semiconductor device for photovoltaic, optoelectronic or electronic applications, comprising a film (1') of semiconductor material and a support (2) which is a cellular structure bonded to the surface of said film, the cell (2') walls (2") of which are perpendicular to the surface of the film (1') and are composed of at least two materials (2a, 2b) having different thermal expansion coefficients suitable for allowing said walls to deform under the effect of a heat treatment.
